# EUROPEAN PATENT SPECIFICATION

(11) **EP 2 931 014 B1**
(45) Date of publication and mention of the grant of the patent: **14.11.2018**
(21) Application number: 12889589.3
(22) Date of filing: 07.12.2012
(51) Int. Cl.: H05K 13/04, H05K 13/08

(54) **APPARATUS AND METHOD FOR GENERATING MOUNTING DATA, AND SUBSTRATE MANUFACTURING SYSTEM**
VORRICHTUNG UND VERFAHREN ZUR ERZEUGUNG VON MONTAGEDATEN UND SUBSTRATHERSTELLUNGSSYSTEM
APPAREIL ET PROCÉDÉ POUR GÉNÉRER DES DONNÉES DE MONTAGE ET SYSTÈME DE FABRICATION D'UN SUBSTRAT

(43) Date of publication of application: 14.10.2015
(73) Proprietor: FUJI Corporation, Chiryu Aichi (JP)
(72) Inventor: YAMAZAKI Atsushi, Chiryu-shi Aichi 472-8686 (JP)
(74) Representative: Grünecker Patent- und Rechtsanwälte PartG mbB
(86) International application number: PCT/JP2012/081764
(87) International publication number: WO 2014/087535

(56) References cited:
- EP-A1- 0 823 079
- JP-A- H0 422 199
- JP-A- H02 144 704
- JP-A- 2002 124 799
- JP-A- 2003 060 396
- JP-A- 2004 213 562
- JP-A- 2007 311 472
- JP-A- 2009 038 340
- JP-A- 2011 103 317
- JP-B2- 4 836 100

## Description

### Technical Field

The present invention relates to a mounting data creating device which mounts a component on a board and creates mounting data without having to prepare component data or sequence data in advance, a creating method thereof, and a board production system which produces the board by using the created mounting data.

### Background Art

When a board is produced by using a component mounting machine, it is necessary to create image processing data or sequence data, and it is necessary to check suction and mounting of the component. For this reason, component data is created in a manual used outside of the device, or is automatically created inside the device. The component data is converted into data used inside the device in combination with mounting position data obtained from CAD data. As a data creating device of this type, the data creating device disclosed in PTL 1 is known.

Document JP 4 836 100 B2 (PTL 2) discloses a generating method for electronic component mounting data for mounting an electronic component on a substrate. The method comprises a substrate picture acquiring process for acquiring a substrate picture being an image of a side of the substrate, where the electronic component is mounted, a component picture acquiring process for acquiring a component picture obtained by right/left-inverting or up/down-inverting the image of a side of the electronic component, where it is mounted so as to face the substrate, a display process for displaying the component picture on the substrate picture in the same scale as the substrate picture and in a movable mode, a coordinate calculating process for calculating a coordinate of the electronic component, which is displayed on the substrate picture, and a data generating process for generating electronic component mounting data for mounting the electronic component on the substrate based on the calculated coordinate.

Document EP 0 823 079 A1 (PTL 3) discloses a method for forming mounting data, which includes reading component text data corresponding to to-be-mounted components of individual mounting positions stored in a component electronic catalog, according to mounting-position data including mounting angles relating to the mounting positions formed on the to-be-mounted components, by using the component electronic catalog that has stored image data concerning various types of components including the to-be-mounted components as well as component text data necessary for component mounting including configurations and dimensions of the components. The method also includes forming mounting data for a mounter to receive components and mount them to specified mounting positions according to the mounting-position data as well as the component.

Document JP 2007 311472 A (PTL 4) discloses an image acquisition method for component-recognition-data preparation, and a component mounting machine. A target-component transfer member with a target component for component-recognition-data preparation mounted thereon is transferred to a prescribed position on a substrate transfer device. A recognition mark attached to the transferred target-component transfer member is imaged by a substrate recognition camera which is arranged in a mounting head and has a variable view angle, so as to acquire image data. It is discriminated whether it is the target-component transfer member or a substrate on the basis of the acquired image data. When the discrimination result shows that it is the target-component transfer member, the substrate recognition camera is moved to the prescribed position on the target-component transfer member. The target component mounted on the target-component transfer member is imaged while expanding the view angle of the substrate recognition camera so as to acquire image data of the target component.

Document JP 2004 213562 A (PTL 5) discloses a component recognition data creation method and creating apparatus to create a recorded component recognition data of the component information to be used for mounting electronic components . This component recognition data creating method is applied to a device for recognizing the electronic component from image data photographing the electronic component and creates the component recognition data recorded with the recognition conditions of the electronic component. This method includes to input external appearance information of the electronic component, photograph the electronic component based on the input external appearance information, specify the type of the electronic component by measuring feature items of the body of the electronic component and electrodes from the image data obtained by the photographing, select a recognition algorithm fitted to the specified component type from the prepared recognition algorithm group and automatically select the component shape data necessary for the recognition of the selected recognition algorithm.

### Citation List

### Patent Literature

PTL 1: JP-A-2004-179299
PTL 2: JP 4 836 100 B2
PTL 3: EP 0 823 079 A1
PTL 4: JP 2007 311472 A
PTL 5: JP 2004 213562 A

### Summary of Invention

### Technical Problem

However, if data is created according to a sequence in the related art in order to produce one or more testing boards or trial boards, it takes a lot of time to create the data. Therefore, a method has been desired in which mounting data for producing the board is created as simple as possible by saving time and labor required for preparing component data or component mounting sequence data in advance, and by mounting a component on the board while combining a manual operation therewith.

The present invention is made in view of the above-described requirement, and an object thereof is to provide a mounting data creating device which mounts a component on a board and creates mounting data without having to prepare component data or sequence data in advance, a creating method thereof, and a board production system.

### Solution to Problem

In a mounting data creating device according to the invention disclosed in Claim 1 which creates mounting data for producing a board while mounting a component on the board, the mounting data creating device includes a mounting head that has a suction nozzle for sucking the component, and that is configured to mount the component sucked by the suction nozzle on the board, a component setting table for setting the component to be mounted on the board, a first imaging device that is configured to image the component set on the component setting table, from above, a second imaging device that is configured to image the component sucked by the suction nozzle, from below, a robot that has a moving head for moving the mounting head relative to the board in an XY plane, a top shape data creating unit that is configured to create top shape data of the component, based on top shape image data of the component which is imaged by the first imaging device, a suction nozzle positioning unit that is configured to position the suction nozzle at a component suction position by moving the robot, based on top shape data of the component which is created by the top shape data creating unit, a bottom shape data creating unit that is configured to create bottom shape data of the component, based on bottom shape image data of the component which is imaged by the second imaging device, a mounting position designation unit that is configured to designate a position for mounting the component on the board, and a mounting data creating unit that is configured to create the mounting data for mounting the component on the board, based on component data having top shape data and bottom shape data which are created by the top shape data creating unit and the bottom shape data creating unit, and data of the component mounting position designated by the mounting position designation unit.

According to the invention disclosed in Claim 1, component shape data is created by simply placing the component at a predetermined location and imaging the component. Based on the component shape data, the component can be sucked, and the component can be mounted on the board by designating which location on the board is suitable for mounting the component. In this manner, mounting data can be created. Accordingly, it is not necessary to prepare component data or sequence data before the board is produced, and thus it is possible to considerably reduce the number of processes required for producing the board.

In the mounting data creating device according to Claim 1, the mounting data creating device according to the invention disclosed in Claim 2 further includes a height measurement unit that is configured to measure a height of the component. Height data of the component which is measured by the height measurement unit is registered in the component data.

According to the invention disclosed in Claim 2, the height measurement of the component enables accurate positioning of the suction nozzle when the component is mounted on the board.

In the mounting data creating device according to Claim 1 or 2, the mounting data creating device according to the invention disclosed in Claim 3 further includes a mounting position correction amount calculation unit that is configured to calculate a correction amount of the mounting position, based on image data obtained in such a way that the component mounting position designated by the mounting position designation unit is designated by using a mounting pattern formed in advance on the board and the designated mounting pattern is imaged by the first imaging device.

According to the invention disclosed in Claim 3, it is possible to correct the position for mounting the component on the board by imaging the mounting pattern. Accordingly, even when a position of the board is not accurate, it is possible to accurately mount the component at a designated position.

In the mounting data creating device according to any one of Claims 1 to 3, the mounting data creating device according to the invention disclosed in Claim 4 adopts a configuration in which the first imaging device includes a component top face imaging camera for imaging the component from above, and a board imaging camera for imaging a mark on the board.

According to the invention disclosed in Claim 4, it is possible to accurately acquire component shape data by using the component top face imaging camera.

In the mounting data creating device according to Claim 4, the mounting data creating device according to the invention disclosed in Claim 5 adopts a configuration in which in a case of the robot, there are provided two robots, and in which the mounting head and the board imaging camera are disposed in one robot, and the component top face imaging camera is disposed in the other robot.

According to the invention disclosed in Claim 5, the component top face imaging camera is disposed in the other robot. In this manner, it is possible to prevent one robot from increasing in weight, thereby enabling the mounting head to move fast.

In the mounting data creating device according to any one of Claims 1 to 5, the mounting data creating device according to the invention disclosed in Claim 6 further includes inspection means for inspecting the mounting position of the component mounted on the board. The mounting data is edited, based on an inspection result of the inspection means, and the board is produced by using the edited mounting data.

According to the invention disclosed in Claim 6, it is possible to edit the mounting data by feeding back the inspection result of the inspection means. Accordingly, it is possible to minimize the number of defective boards.

A mounting data creating method according to the invention disclosed in Claim 8 includes causing a first imaging device to image a component from above, creating top shape data of the component, based on top shape image data of the component, positioning a suction nozzle for sucking the component at a suction position, based on top shape data, causing a second imaging device to image the component from below, creating bottom shape data of the component, based on bottom shape image data of the component, designating a mounting position of the component sucked by the suction nozzle, and creating mounting data for mounting the component on a board, based on component data having top shape data and bottom shape data, and data of the mounting position.

According to the invention disclosed in Claim 8, component shape data is created by simply placing the component at a predetermined location and imaging the component. Based on the component shape data, the component can be sucked, and the component can be mounted on the board by designating which location on the board is suitable for mounting the component. In this manner, mounting data can be created.

A board production system according to the invention disclosed in Claim 7 includes a mounting head that has a suction nozzle for sucking a component, and that is configured to mount the component sucked by the suction nozzle on a board, a component setting table for setting the component to be mounted on the board, a first imaging device that is configured to image the component set on the component setting table, from above, a second imaging device that is configured to image the component sucked by the suction nozzle, from below, a robot that has a moving head for moving the mounting head relative to the board in an XY plane, a top shape data creating unit that is configured to create top shape data of the component, based on top shape image data of the component which is imaged by the first imaging device, a suction nozzle positioning unit that is configured to position the suction nozzle at a component suction position by moving the robot, based on top shape data of the component which is created by the top shape data creating unit, a bottom shape data creating unit that is configured to create bottom shape data of the component, based on bottom shape image data of the component which is imaged by the second imaging device, a mounting position designation unit that is configured to designate a position for mounting the component on the board, a mounting data creating unit that is configured to create the mounting data for mounting the component on the board, based on component data having top shape data and bottom shape data which are created by the top shape data creating unit and the bottom shape data creating unit, and data of the component mounting position designated by the mounting position designation unit, and a data reading unit that is configured to read sequence data of the mounting data created by the mounting data creating unit.

According to the invention disclosed in Claim 7, in addition to an advantageous effect disclosed in Claim 1, a board B can be produced by using the mounting data created as described above. Therefore, it is possible to build a board production system which considerably reduces the number of processes for producing the board B.

### Brief Description of Drawings

[Fig. 1] Fig. 1 is a plan view of a preferred component mounting machine according to an embodiment of the present invention.
[Fig. 2] Fig. 2 is a view illustrating a suction nozzle held by a mounting head of the component mounting machine.
[Fig. 3] Fig. 3 is a view illustrating a top face of a board.
[Fig. 4] Fig. 4 is a block diagram illustrating a control device for controlling the component mounting machine.
[Fig. 5] Fig. 5 is a view illustrating a flowchart in creating mounting data for producing a board.
[Fig. 6] Fig. 6 illustrates an operation of the component mounting machine, and is a view illustrating a state where a component is set on a component setting table.
[Fig. 7] Fig. 7 illustrates an operation of the component mounting machine, and is a view illustrating a state where the component set on the component setting table is imaged by a top face imaging camera.
[Fig. 8] Fig. 8 illustrates an operation of the component mounting machine, and is a view illustrating a state where the component set on the component setting table is sucked by a suction nozzle.
[Fig. 9] Fig. 9 illustrates an operation of the component mounting machine, and is a view illustrating a state where a designated mounting position is imaged by the top face imaging camera.
[Fig. 10] Fig. 10 illustrates an operation of the component mounting machine, and is a view illustrating a state where the component sucked by the suction nozzle is mounted on the board.
[Fig. 11] Fig. 11 illustrates an operation of the component mounting machine, and is a view illustrating a state where a mounting state of the component mounted on the board is inspected.
[Fig. 12] Fig. 12 is a view illustrating component data.
[Fig. 13] Fig. 13 is a view illustrating mounting sequence data.

### Description of Embodiments

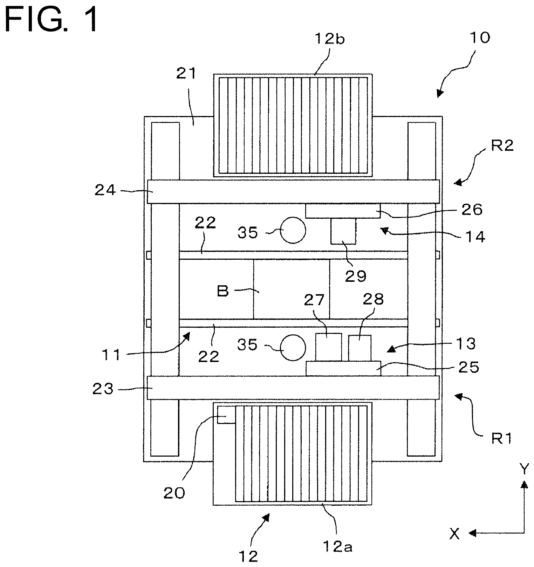

Hereinafter, an embodiment according to the present invention will be described with reference to the drawings. Fig. 1 illustrates a component mounting machine 10. The component mounting machine 10 includes a board conveyance device 11, a component supply device 12, a component transfer device 13, and an inspection device 14.

The board conveyance device 11 is disposed on a base 21 of the component mounting machine 10, conveys a board B along a conveyance rail 22, and positions the board B in a mounting stage. In Fig. 1, a conveyance direction of the board B is referred to as an X-axis direction, and a direction orthogonal to the X-axis direction is referred to as a Y-axis direction.

The component supply device 12 includes tape feeder-type component supply units 12a and 12b arranged on both sides of the board conveyance device 11. One component supply unit 12a has a component setting table 20 on which a worker places a component when mounting data is created.

The component transfer device 13 and the inspection device 14 respectively include XY robots R1 and R2. The XY robots R1 and R2 have Y-axis moving tables 23 and 24 supported to be respectively movable in the Y-axis direction at a position above the base 21, and X-axis moving tables 25 and 26 supported to be respectively movable in the X-axis direction on the Y-axis moving tables 23 and 24. A mounting head 27 and a board imaging camera 28 are attached to one X-axis moving table 25.

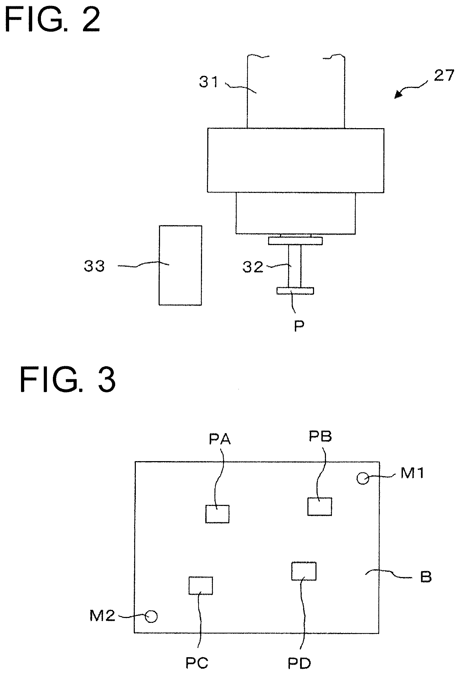

The board imaging camera 28 acquires board position information by imaging fiducial marks M1 and M2 (refer to Fig. 3) disposed on the board B positioned in the mounting stage by the board conveyance device 11. The fiducial marks M1 and M2 serve as a reference when a component P is mounted on the board B at component mounting positions (mounting pattern) PA to PD. Based on board position information of the two fiducial marks M1 and M2 imaged by the board imaging camera 28, inclination of the board B can be recognized. In addition, based on the board position information of any one between the fiducial marks M1 and M2, positional deviation (ΔX1 and ΔY1) of the board B can be recognized. The positional deviation and the inclination are corrected during the component mounting.

A component top face imaging camera 29 serving as a first imaging device for imaging the component P from above is attached to the other X-axis moving table 26. The component top face imaging camera 29 is configured to be capable of imaging the overall component P even if the component P has a large size.

As illustrated in Fig. 2, a nozzle holder 31 is supported in the mounting head 27 so as to be freely lifted and lowered in a vertical direction (Z-axis direction) orthogonal to the X-axis direction and the Y-axis direction, and so as to be rotatable around the Z-axis. A suction nozzle 32 for sucking the component P is mounted on the nozzle holder 31 so as to be attachable and detachable. In addition, a side face recognizing camera 33 which laterally images the component P sucked by the suction nozzle 32 and measures a height dimension of the component P based on side face image data of the imaged component P is attached to the mounting head 27.

A component bottom face imaging camera 35 serving as a second imaging device for imaging the component P sucked by the suction nozzle 32 from below is disposed between the board conveyance device 11 and the component supply units 12a and 12b. While the component P is fed to the board B by the respective component supply units 12a and 12b, the component bottom face imaging camera 35 images a bottom face of the component P sucked by the suction nozzle 32. Based on image data of the imaged bottom face of the component, the component bottom face imaging camera 35 recognizes misalignment and angular deviation of the component P with respect to the center of the suction nozzle 32, and based on both of these, corrects a movement amount of the mounting head 27 in the XY directions, thereby correcting an angular position of the nozzle holder 31.

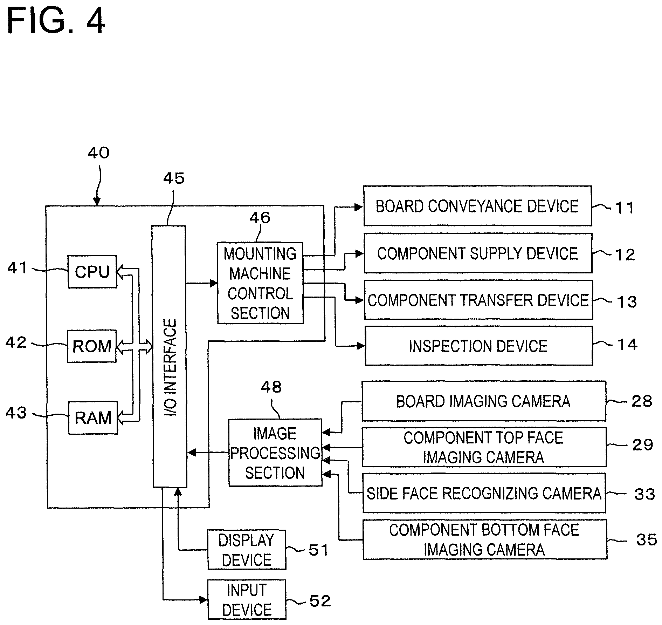

The component mounting machine 10 is controlled by a control device 40 illustrated in Fig. 4. The control device 40 includes a CPU 41 serving as a central processing device, a ROM 42 and a RAM 43 which serve as a storage device, and an I/O interface 45. A mounting machine control section 46 for controlling the board conveyance device 11, the component supply device 12, the component transfer device 13, and the inspection device 14, and an image processing section 48 for performing image processing on image data captured by the board imaging camera 28, the component top face imaging camera 29, and the component bottom face imaging camera 35 are connected to the I/O interface 45. In addition, a display device 51 such as an LCD or a CRT, and an input device 52 such as a keyboard or a mouse are connected to the I/O interface 45.

When producing one or more testing boards, the component mounting machine 10 having the above-described configuration can create producing-purpose mounting data while mounting a component on a testing board without having to prepare mounting data (component data and sequence data) in advance.

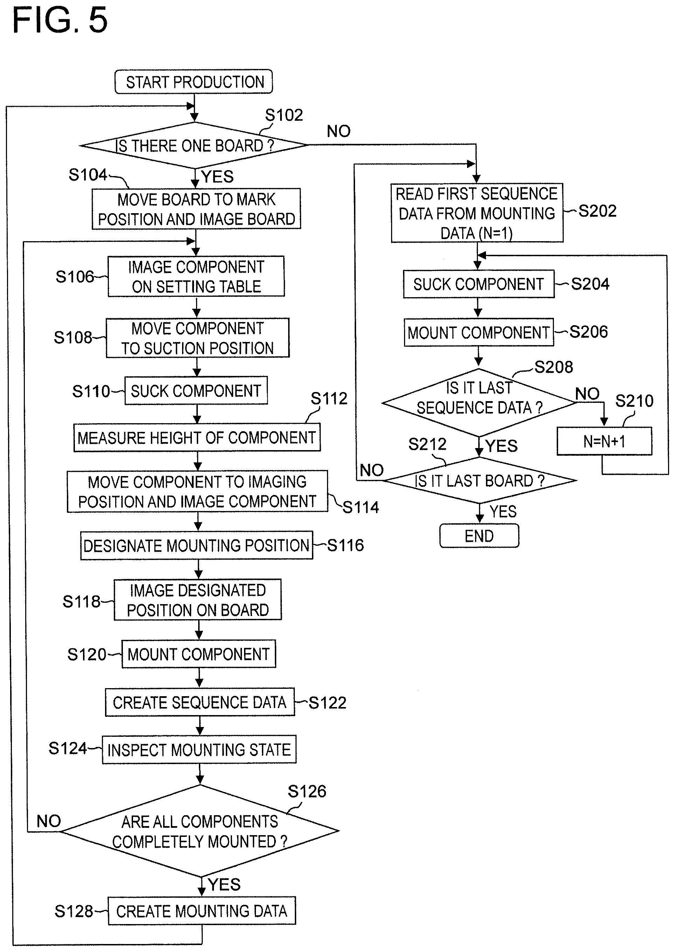

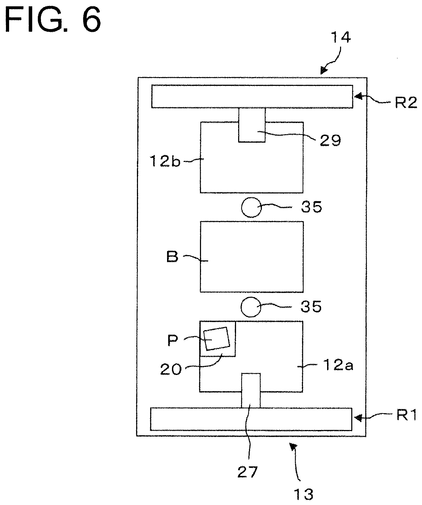

Hereinafter, with reference to views illustrating operation states of the component mounting machine 10 in Figs. 6 to 10, a control program which is executed by the control device 40 (CPU 41) in order to create mounting data for producing the board (testing board) B and to produce the board B by using the mounting data will be described based on a flowchart illustrated in Fig. 5. As illustrated in Fig. 6, before the component P is mounted on the board B, the board B is positioned in a mounting stage by the board conveyance device 11 (refer to Fig. 1). In addition, the display device 51 instructs a worker so that the component P to be mounted on the board B is placed on the component setting table 20. Based on this instruction, the worker places the component P at any desired position on the component setting table 20.

First, in Step S102 in Fig. 5, it is determined whether or not the board B positioned in the mounting stage is first board (testing board). In a case of first board B, the flow proceeds to Step S104. In a case of the board B subsequent to the second one, the flow proceeds to Step S202.

In Step S104, the board imaging camera 28 disposed in the robot R1 on the component transfer device 13 side images the fiducial marks M1 and M2 on the board B positioned in the mounting stage. That is, the robot R1 on the component transfer device 13 side is moved in the XY directions, and the board imaging camera 28 images the fiducial marks M1 and M2 on the board B.

Then, based on positional information (coordinate data) of the imaged fiducial marks M1 and M2, positional deviation amounts (ΔX1 and ΔY1) and inclination (Δθ) are calculated in the XY directions of the board B with respect to a machine datum, and the positional deviation amount and the inclination are stored in a predetermined storage area of the RAM 43 of the control device 40. Based on the positional deviation amount and the inclination, a position for mounting the component P on the board B is corrected.

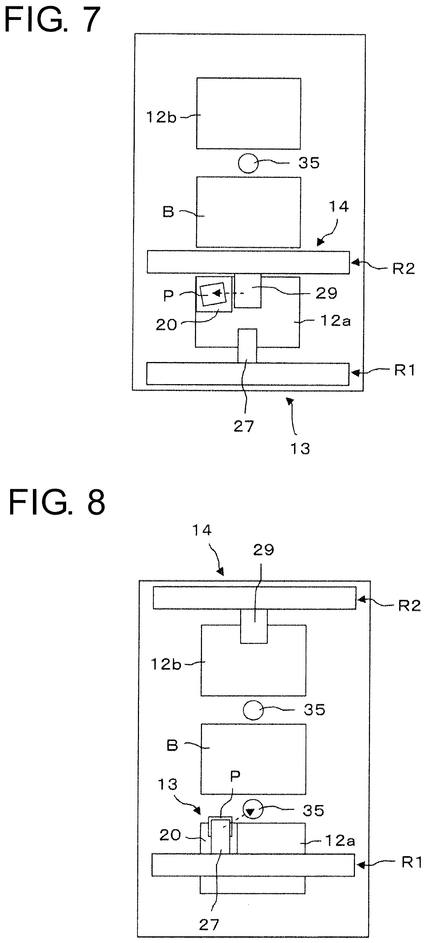

Next, in Step S106, as illustrated in Fig. 7, the component top face imaging camera 29 disposed in the robot R2 on the inspection device 14 side images a top face of the component P on the component setting table 20. That is, the robot R2 on the inspection device 14 side is moved in the XY directions, and the component top face imaging camera 29 is positioned above the component P on the component setting table 20 so as to image the top face of the component P.

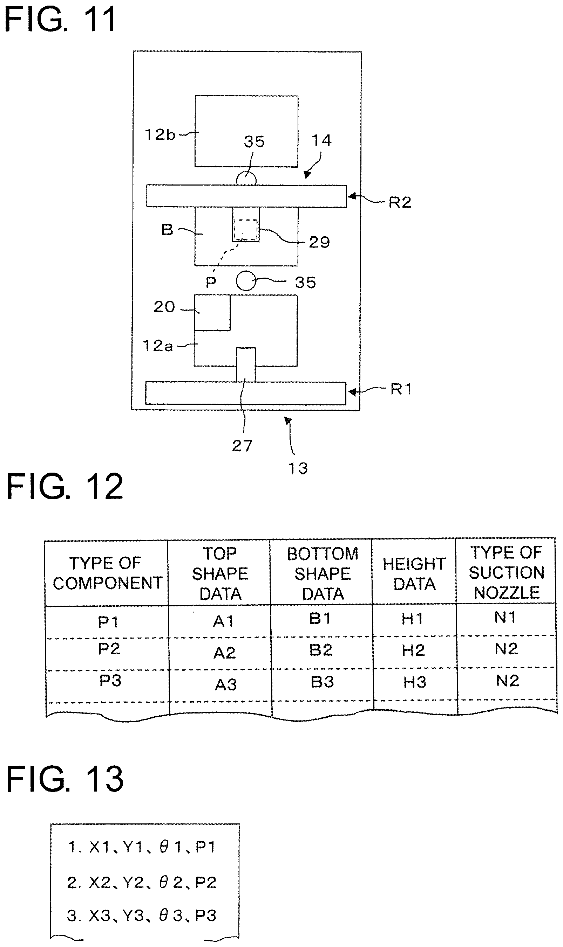

Based on image data of the imaged top face of the component, suction-purpose component shape data (top shape data) for suctioning the component P is created. Concurrently, suction coordinate positions (X0, Y0, and θ0) in the center on the top face (suction surface) of the component P is calculated by using the suction-purpose component shape data. A type of the suction nozzle 32 to be used for sucking the component P is determined. The suction-purpose component shape data and the type of the suction nozzle to be used are registered in a predetermined column of the component data (refer to Fig. 12) stored in the RAM 43 of the control device 40.

Next, in Step S108, based on the suction coordinate position data registered in the RAM 43, the robot R1 on the component transfer device 13 side is moved in the XY directions. As illustrated in Fig. 8, the suction nozzle 32 (refer to Fig. 1) held by the mounting head 27 is positioned at a position coincident with the center of the top face of the component P on the component setting table 20. In this state, the nozzle holder 31 (suction nozzle 32) is lowered, and the suction nozzle 32 sucks the component P on the component setting table 20 (Step S110) . At this time, the side face recognizing camera 33 which acquires a side face image of the component P measures a height of the component P (Step S112). Data of the measured height of the component P is registered in a predetermined column of the component data stored in the RAM 43.

Next, in Step S114, the mounting head 27 of the component transfer device 13 is moved to a position above the component bottom face imaging camera 35 which images the component P sucked by the suction nozzle 32 from below. At the position, the component bottom face imaging camera 35 images the component P from below. Then, based on image data of the imaged bottom face of the component, positioning-purpose component shape data (bottom shape data) of the bottom face of the component to be mounted on the board B is created. The positioning-purpose component shape data is registered in a predetermined column of the component data stored in the RAM 43.

Concurrently, suction positional deviation amounts (ΔX0, ΔY0, and Δθ0) with respect to the center of the suction nozzle 32 on the bottom face of the component sucked by the suction nozzle 32 are calculated by using the created positioning-purpose component shape data, and are stored in a predetermined storage area in the RAM 43. Based on the suction positional deviation amounts, a position of the mounting head 27 is corrected when the component P is mounted.

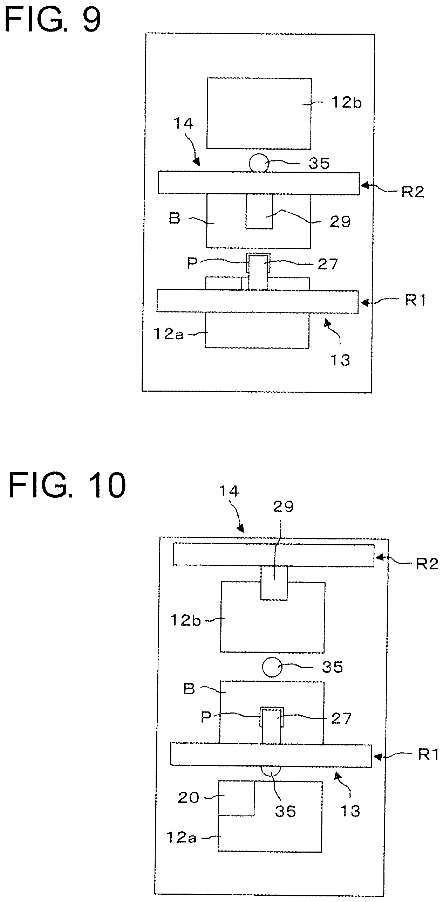

Next, in Step S116, according to an input to the input device 52, positions (X1, Y1, and θ1) for mounting the component P on the board B are designated in a board coordinate system in which the fiducial marks M1 and M2 of the board B serve as reference positions. Specifically, the component mounting positions are designated by designating coordinate positions (X1 and Y1) on a mounting pattern formed on the board B in advance in order to mount the component P thereon. Thereafter, in Step S118, the robot R2 on the inspection device 14 side is moved. The component top face imaging camera 29 is positioned at the coordinate positions of the mounting pattern so that the component top face imaging camera 29 disposed in the robot R2 images the mounting pattern. Then, the component top face imaging camera 29 images the mounting pattern (state in Fig. 9) .

Based on the captured image data, deviation amounts (ΔX2, ΔY2, and Δθ2) of the mounting pattern with respect to the center of the component top face imaging camera 29, that is, deviation amounts of the mounting pattern with respect to the reference positions of the board B are calculated as a correction value, and the correction value is registered in a predetermined storage area in the RAM 43. Based on the correction value, a position for mounting the component P on the board B is corrected.

Next, inStepS120, the component mounting positions (X1, Y1, and θ1) designated in the board coordinate system are converted into a machine coordinate system. The mounting head 27 disposed in the robot R1 on the component transfer device 13 side is positioned at a predetermined coordinate position (component mounting position).

In this case, in Step S104 described above, the deviation amounts (ΔX1 and ΔY1) and the inclination (Δθ1) have been calculated in the XY directions of the board B with respect to the machine coordinate system. In addition, in Step S118 described above, the deviation amounts (ΔX2 and ΔY2) and the inclination (Δθ2) of the mounting pattern have been calculated. Accordingly, when the mounting head 27 is positioned at a predetermined position in the machine coordinate system, errors thereof are corrected.

If the mounting head 27 is positioned at the designated mounting position, the nozzle holder 31 (suction nozzle 32) is lowered by a predetermined amount in accordance with height data of the component P which is registered in the component data, and the component P is accurately mounted at the mounting position on the board B (state in Fig. 10).

In this manner, in Step S122, as illustrated in Fig. 13, mounting sequence data is created for each component P (P1, P2, and so forth), and the data items are sequentially stored in the ROM 42 of the control device 40.

Next, in Step S124, as illustrated in Fig. 11, the component top face imaging camera 29 disposed in the robot 2 on the inspection device 14 side is positioned at a position above the component P mounted on the board B. The component top face imaging camera 29 images the component P mounted on the board B from above. Then, based on image data of the imaged component P, a mounting state of the component P is inspected, thereby causing the control device 40 to determine whether or not the mounting state is satisfactory.

Next, in Step S126, it is determined whether or not all components P to be mounted on the board B are completely mounted. When the determination result is NO, the flow returns to Step S106 described above. In order to image the second component P placed on the component setting table 20 (placed on the component setting table 20 by a worker while the first component P is mounted on the board B) by using the component top face imaging camera 29 disposed in the robot R2 on the inspection device 14 side, the component top face imaging camera 29 is moved in the XY directions. The component top face imaging camera 29 images the component P on the component setting table 20 from above. Thereafter, Steps S106 to S126 as described above are repeated, and the second component P is mounted at the designated mounting position on the board B.

In Step S126, if it is determined that all components P to be mounted on the board B are completely mounted by sequentially mounting multiple components P on the board B in this way, the determination result in Steps S126 shows YES. In Step S128 subsequent thereto, mounting data (component data and sequence data) for mounting the component P on the board B is completely created. The mounting data is stored in the ROM 42 of the control device 40.

That is, the mounting data is configured to include top shape data and bottom shape data which are created in Step S104 and Step S106 described above, the component data (refer to Fig. 12) created according to the height data created in Step S112 and the type of the suction nozzle 32, and the sequence data (refer to Fig. 13) for mounting the component which is created according to the mounting position data created in Step S118 described above.

In Step S128, if the mounting data is created, the flow of the program returns to Step S102, and it is determined whether or not the mounted board is the first board (testing board). However, in this case, since the mounted board is not the first board, the flow proceeds to Step S202. Then, in Step S202, the first sequence data is read from the mounting data stored in the ROM 42.

In a case of the sequence data, mounting positions (Xn, Yn, and θn) of the component P mounted on the board B for the first time (N=1) are designated in the board coordinate system, and the type of the suction nozzle 32 to be used is designated.

Based on the sequence data, a predetermined suction nozzle 32 is mounted on the nozzle holder 31, and a component feeder of the component supply unit 12a (12b) for accommodating a predetermined component is controlled. The component P to be mounted on the board B for the first time is supplied to a predetermined position, and is sucked by the suction nozzle 32 (Step S204). Next, the component P sucked by the suction nozzle 32 is imaged by the component bottom face imaging camera 35 while the component P is conveyed to the board B. The deviation amount with respect to the suction nozzle 32 is calculated, and the component P is mounted at a predetermined position on the board B (Step S206).

Next, in Step S208, it is determined whether or not the flow shows the last sequence data for mounting the last component. In a case of NO, 1 is added to N (N=2) in Step S210, and the flow returns to Step S204. In Step S204, the component P to be subsequently mounted on the board B is supplied to a predetermined position, and is sucked by the suction nozzle 32. In Step S206, the component P is mounted at a predetermined position on the board B.

In Step S208, if it is determined that the flow shows the last sequence data for mounting the last component in this way, in Step S212, it is then determined whether or not the mounted board is the last board B. Then, when the mounted board is the last board B, the program is completed. When the mounted board is not the last board B, the flow returns to Step S202 described above. The second sequence data is read from the mounting data. Hereinafter, the above-described Steps are repeated.

In this manner, image processing data of the component P is created by simply setting the component P to be mounted on the testing board B on the component setting table 20. Accordingly, the component P can be sucked by the suction nozzle 32. It is possible to create coordinate data for mounting the component by designating the mounting position of the component P sucked by the suction nozzle 32. According to this configuration, it is possible to easily create the mounting data for producing the testing board B. Thereafter, based on the created mounting data, the board B can be produced.

According to Step S106 in the above-described flowchart, a top shape data creating unit for creating top shape data of the component P is configured. Similarly, according to Step S108, a suction nozzle positioning unit for positioning the suction nozzle 32 at the component suction position is configured. According to Step S114, a bottom shape data creating unit for creating bottom shape data of the component P is configured. According to Step S116, a mounting position designation unit for designating a position for mounting the component on the board B is configured. According to Step S126, a mounting data creating unit for creating the mounting data for mounting the component on the board B is configured. In addition, according to Step S202, a data reading unit for reading the sequence data of the mounting data is configured.

The mounting data creating device according to the above-described embodiment includes the mounting head 27 that has the suction nozzle 32 for sucking the component P, and that mounts the component P sucked by the suction nozzle 32 on the board B, the component setting table 20 for setting the component P to be mounted on the board B, the component top face imaging camera 29 serving as the first imaging device that images the component P set on the component setting table 20 from above, the component bottom face imaging camera 35 serving as the second imaging device that images the component P sucked by the suction nozzle 32 from below, the robot R1 that moves the mounting head 27 relative to the board in an XY plane, the top shape data creating unit S106 that creates top shape data of the component P, based on top shape image data of the component P which is imaged by the component top shape imaging camera 29, the suction nozzle positioning unit S108 that positions the suction nozzle 32 at the component suction position by moving the X-axis and Y-axis moving tables 25 and 23, based on top shape data of the component P which is created by the top shape data creating unit S106, the bottom shape data creating unit S114 that creates bottom shape data of the component P, based on bottom shape image data of the component P which is imaged by the component bottom face imaging camera 35, the mounting position designation unit S116 that designates the position for mounting the component on the board B, and the mounting data creating unit S126 that creates the mounting data for mounting the component on the board B, based on component data having top shape data and bottom shape data which are created by the top shape data creating unit S106 and the bottom shape data creating unit S114, and data of the component mounting position designated by the mounting position designation unit S116.

According to the mounting data creating device having the above-described configuration, the component top face imaging camera 29 images the component P so as to create component shape data by simply placing the component P on the component setting table 20. Based on the component shape data, the suction nozzle 32 can suck the component P, and a worker designates which location on the board B is suitable for mounting the component P. In this manner, the component P can be mounted on the board B, and the mounting data can be created. Accordingly, it is not necessary to prepare the component data or the sequence data before the board B is produced, and thus it is possible to considerably reduce the number of processes required for producing the board B. In particular, the mounting data creating device is effectively used when one or some testing or trial boards B are produced.

In addition to the above-described configuration of the mounting data creating device, the board production system according to the above-described embodiment includes the data reading unit S202 that reads the sequence data of the mounting data created by the mounting data creating unit S126.

According to the board production system having the above-described configuration, it is possible to produce the board B by using the mounting data created as described above. Therefore, it is possible to build the board production system which considerably reduces the number of processes for producing the board B.

In the above-described embodiment, an example has been described in which the component top face imaging camera 29 for imaging the component P from above is disposed on the inspection device 14 side. However, the component top face imaging camera 29 can be disposed on the component transfer device 13 side. This configuration can omit the inspection device 14, thereby enabling one robot R1 to create the mounting data. In addition, the board imaging camera 28 can be replaced with the component top face imaging camera 29. This configuration can omit the board imaging camera 28.

In the above-described embodiment, an example has been described in which the present invention is applied to the production of the trial board B. However, the present invention can be applied to the production of boards for mass production. That is, with regard to one sheet of the board for mass production, the mounting data is created while the component is mounted thereon as described above. In this manner, the second board and the subsequent boards may be produced by using the created mounting data.

In addition, in the above-described embodiment, examples have been described in which deviation of the board B with respect to the machine datum is calculated by imaging the fiducial marks M1 and M2 disposed on the board B, and in which deviation of the mounting pattern with respect to the reference mark position is calculated by imaging the mounting pattern formed on the board B. However, these examples are not necessary requirements for the present invention.

Furthermore, in the above-described embodiment, the component mounting machine 10 has been described in which the component supply units 12a and 12b are respectively disposed on both sides of the board conveyance device 11, and in which the component bottom face imaging camera 35 is arranged between the component supply units 12a and 12b and the board conveyance device 11. However, the present invention can also be applied to the component mounting machine 10 which includes at least one component supply unit and component bottom face imaging camera.

As described above, without being limited to the configurations described in the embodiment, the present invention can be modified in various ways within the scope not departing from the gist of the present invention disclosed in Claims.

### Industrial Applicability

A mounting data creating device, a creating method and a board production system according to the present invention is suitably used in creating mounting data and producing a board without having to prepare component data or sequence data in advance.

### Reference Signs List

10 ... COMPONENT MOUNTING MACHINE, 11 ... BOARD CONVEYANCE DEVICE, ... 12 COMPONENT SUPPLY DEVICE, 13 ... COMPONENT TRANSFER DEVICE, 14 ... INSPECTION DEVICE, 20 ... COMPONENT SETTING TABLE, 27 ... MOUNTING HEAD, 28 ... BOARD IMAGING CAMERA, 29 ... COMPONENT TOP FACE IMAGING CAMERA, 32 ... SUCTION NOZZLE, 33 ... SIDE FACE RECOGNIZING CAMERA, 35 ... COMPONENT BOTTOM FACE IMAGING CAMERA, 40 ... CONTROL DEVICE, S106 ... TOP SHAPE DATA CREATING UNIT, S108 ... SUCTION NOZZLE POSITIONING UNIT, S114 ... BOTTOM SHAPE DATA CREATING UNIT, S116 ... MOUNTING POSITION DESIGNATION UNIT, S126 ... MOUNTING DATA CREATING UNIT, S202 ... DATA READING UNIT, R1, R2 ... ROBOT, B ... BOARD, P ... COMPONENT

## Claims

1. A mounting data creating device which creates mounting data for producing a board (B) while mounting a component (P) on the board (B), comprising:
a mounting head (27) that has a suction nozzle (32) for sucking the component (P), and that is configured to mount the component (P) sucked by the suction nozzle (32) on the board (B);
a component setting table (20) for setting the component (P) to be mounted on the board (B);
a first imaging device (29) that is configured to image the component (P) set on the component setting table (20), from above;
a second imaging device (35) that is configured to image the component (P) sucked by the suction nozzle (32), from below;
a robot (R1) that has a moving head for moving the mounting head (27) relative to the board (B) in an XY plane;
a top shape data creating unit (S106) that is configured create top shape data of the component (P), based on top shape image data of the component (P) which is imaged by the first imaging device (29);
a suction nozzle positioning unit (S108) that is configured to position the suction nozzle (32) at a component suction position by moving the robot (R1), based on top shape data of the component (P) which is created by the top shape data creating unit (S106);
a bottom shape data creating unit (S114) that is configured to create bottom shape data of the component (P), based on bottom shape image data of the component (P) which is imaged by the second imaging device (35);
a mounting position designation unit (S116) that is configured to designate a position for mounting the component (P) on the board (B); and
a mounting data creating unit (S126) that is configured to create the mounting data for mounting the component (P) on the board (B), based on component data having top shape data and bottom shape data which are created by the top shape data creating unit (S106) and the bottom shape data creating unit (S114), and data of the component mounting position designated by the mounting position designation unit (S116).

2. The mounting data creating device according to Claim 1, further comprising:
a height measurement unit that is configured to measure a height of the component (P),
wherein height data of the component (P) which is measured by the height measurement unit is registered in the component data.

3. The mounting data creating device according to Claim 1 or 2, further comprising:
a mounting position correction amount calculation unit that is configured to calculate a correction amount of the mounting position, based on image data obtained in such a way that the component mounting position designated by the mounting position designation unit (S116) is designated by using a mounting pattern formed in advance on the board (B) and the designated mounting pattern is imaged by the first imaging device (29).

4. The mounting data creating device according to any one of Claims 1 to 3,
wherein the first imaging device includes a component top face imaging camera (29) for imaging the component (P) from above, and a board imaging camera (28) for imaging a mark on the board (B).

5. The mounting data creating device according to Claim 4,
wherein in a case of the robot, there are provided two robots (R1, R2), and
wherein the mounting head (27) and the board imaging camera (28) are disposed in one robot (R1), and the component top face imaging camera (29) is disposed in the other robot (R2).

6. The mounting data creating device according to any one of Claims 1 to 5, further comprising:
inspection means (14) for inspecting the mounting position of the component (P) mounted on the board (B),
wherein the mounting data is edited, based on an inspection result of the inspection means (14), and the board (B) is produced by using the edited mounting data.

7. A board production system comprising:a mounting data creating device according to claim 1, and a data reading unit (S202) that is configured to read sequence data of the mounting data created by the mounting data creating (S126) unit.

8. A mouting data creating method comprising:
causing a first imaging device (29) to image a component (P) from above;
creating top shape data of the component (P), based on top shape image data of the component (P);
positioning a suction nozzle (32) for sucking the component (P) at a suction position, based on top shape data;
causing a second imaging device (35) to image the component (P) from below;
creating bottom shape data of the component (P), based on bottom shape image data of the component (P);
designating a mounting position of the component (P) sucked by the suction nozzle (32); and
creating mounting data for mounting the component (P) on a board (B), based on component data having top shape data and bottom shape data, and data of the mounting position.

## Patentansprüche

1. Montagedaten-Erzeugungsvorrichtung, die Montagedaten zum Produzieren einer Leiterplatte (B) während der Montage einer Komponente (P) auf der Leiterplatte (B) erzeugt, umfassend
einen Montagekopf (27), der eine Saugdüse (32) zum Ansaugen der Komponente (P) aufweist und der dazu konfiguriert ist, die von der Saugdüse (32) angesaugte Komponente (P) auf der Leiterplatte (B) zu montieren;
einen Komponenteneinrichtungstisch (20) zum Einrichten der Komponente (P), die auf der Leiterplatte (B) montiert werden soll;
eine erste Abbildungsvorrichtung (29), die dazu ausgelegt ist, die auf dem Komponenteneinrichtungstisch (20) eingerichtete Komponente (P) von oben abzubilden;
eine zweite Abbildungsvorrichtung (35), die dazu ausgelegt ist, die von der Saugdüse (32) angesaugte Komponente (P) von unten abzubilden;
einen Roboter (R1), der einen beweglichen Kopf aufweist, um den Montagekopf (27) relativ zu der Leiterplatte (B) in einer XY-Ebene zu bewegen;
eine Oberteilform-Datenerzeugungseinheit (S106), die dazu ausgelegt ist, Oberteilformdaten der Komponente (P) basierend auf Oberteilform-Abbildungsdaten der Komponente (P) zu erzeugen, die von der ersten Abbildungsvorrichtung (29) abgebildet wird;
eine Saugdüsen-Positionierungseinheit (S108), die dazu ausgelegt ist, die Saugdüse (32) auf einer Komponentenansaugposition durch Bewegen des Roboters (R1) basierend auf den Oberteilformdaten der Komponente (P) zu positionieren, die von der Oberteilform-Datenerzeugungseinheit (S106) erzeugt werden;
eine Unterteilform-Datenerzeugungseinheit (S114), die dazu ausgelegt ist, Unterteilformdaten der Komponente (P) basierend auf Unterteilform-Abbildungsdaten der Komponente (P) zu erzeugen, die von der zweiten Abbildungsvorrichtung (35) abgebildet wird;
eine Montageposition-Kennzeichnungseinheit (S116), die dazu ausgelegt ist, eine Position für die Montage der Komponente (P) auf der Leiterplatte (B) zu kennzeichnen; und
eine Montagedaten-Erzeugungseinheit (S126), die dazu ausgelegt ist, die Montagedaten zur Montage der Komponente (P) auf der Leiterplatte (B) basierend auf Komponentendaten erzeugen, welche die Oberteilformdaten und die Unterteilformdaten aufweisen, die von der Oberteilform-Datenerzeugungseinheit (S106) und der Unterteilform-Datenerzeugungseinheit (S114) erzeugt werden, und Daten der Komponentenmontageposition, die von der Montageposition-Kennzeichnungseinheit (S116) gekennzeichnet sind.

2. Montagedaten-Erzeugungsvorrichtung nach Anspruch 1, des Weiteren umfassend:
eine Höhenmessungseinheit, die dazu ausgelegt ist, eine Höhe der Komponente (P) zu messen,
wobei die Höhendaten der Komponente (P), die von der Höhenmessungseinheit gemessen werden, in den Komponentendaten registriert werden.

3. Montagedaten-Erzeugungsvorrichtung nach Anspruch 1 oder 2, des Weiteren umfassend:
eine Montageposition-Korrekturgrößenberechnungseinheit, die dazu ausgelegt ist, eine Korrekturgröße der Montageposition basierend auf erhaltenen Bilddaten auf solche Weise zu berechnen, dass die Komponentenmontageposition, die von der Montageposition-Kennzeichnungseinheit (S116) gekennzeichnet ist, unter Verwendung eines Montagemusters gekennzeichnet wird, das vorab auf der Leiterplatte (B) ausgebildet wird, und das gekennzeichnete Montagemuster von der ersten Abbildungsvorrichtung (29) abgebildet wird.

4. Montagedaten-Erzeugungsvorrichtung nach einem der Ansprüche 1 bis 3,
wobei die erste Abbildungsvorrichtung eine Komponentenoberseiten-Abbildungskamera (29) zum Abbilden der Komponente (P) von oben beinhaltet, und eine Leiterplatten-Abbildungskamera (28) zum Abbilden einer Markierung auf der Leiterplatte (B).

5. Montagedaten-Erzeugungsvorrichtung nach Anspruch 4,
wobei im Falle des Roboters zwei Roboter (R1, R2) vorgesehen sind, und
wobei der Montagekopf (27) und die Leiterplatten-Abbildungskamera (28) in einem Roboter (R1) angeordnet sind und die Komponentenoberseiten-Abbildungskamera (29) in dem anderen Roboter (R 2) angeordnet ist.

6. Montagedaten-Erzeugungsvorrichtung nach einem der Ansprüche 1 bis 5, des Weiteren umfassend:
ein Prüfungsmittel (14) zum Prüfen der Montageposition der auf der Leiterplatte (B) montierten Komponente (P),
wobei die Montagedaten basierend auf einem Prüfungsergebnis des Prüfungsmittels (14) bearbeitet werden und die Leiterplatte (B) unter Verwendung der bearbeiteten Montagedaten produziert wird.

7. Leiterplattenherstellungssystem, umfassend: eine Montagedaten-Erzeugungsvorrichtung nach Anspruch 1 und eine Datenleseeinheit (S202), die dazu ausgelegt ist, Sequenzdaten der Montagedaten zu lesen, die von der Montagedaten-Erzeugungsvorrichtung (S126) erzeugt werden.

8. Montagedaten-Erzeugungsverfahren, umfassend:
Veranlassen einer ersten Abbildungsvorrichtung (29) dazu, eine Komponente (P) von oben abzubilden;
Erzeugen von Oberteilformdaten der Komponente (P) basierend auf Oberteilform-Abbildungsdaten der Komponente (P);
Positionieren einer Saugdüse (32) zum Ansaugen der Komponente (P) auf einer Ansaugposition basierend auf Oberteilformdaten;
Veranlassen einer zweiten Abbildungsvorrichtung (35) dazu, die Komponente (P) von unten abzubilden;
Erzeugen von Unterteilformdaten der Komponente (P) basierend auf Unterteilform-Abbildungsdaten der Komponente (P);
Kennzeichnen einer Montageposition der Komponente (P), die von der Saugdüse (32) angesaugt wird; und
Erzeugen von Montagedaten zum Montieren der Komponente (P) auf einer Leiterplatte (B) basierend auf Komponentendaten, die Oberteilformdaten und Unterteilformdaten aufweisen, sowie Daten der Montageposition.

## Revendications

1. Dispositif de création de données de montage, qui crée des données de montage pour produire une carte (B) tout en montant un composant (P) sur la carte (B), comprenant :
une tête de montage (27) qui possède une buse d'aspiration (32) pour aspirer le composant (P) et qui est conçue pour monter le composant (P) aspiré par la buse d'aspiration (32) sur la carte (B) ;
une table de pose de composant (20) pour la pose du composant (P) devant être monté sur la carte (B) ;
un premier dispositif de formation d'image (29) qui est conçu pour former une image du composant (P) posé sur la table de pose de composant (20), de dessus ;
un second dispositif de formation d'image (35) qui est conçu pour former une image du composant (P) aspiré par la buse d'aspiration (32), de dessous ;
un robot (R1) qui possède une tête mobile pour déplacer la tête de montage (27) par rapport à la carte (B) dans un plan XY ;
un module de création de données de forme de dessus (S106) qui est conçu pour créer des données de forme de dessus du composant (P), sur la base de données d'image de forme de dessus du composant (P) dont une image est formée par le premier dispositif de formation d'image (29) ;
un module de positionnement de buse d'aspiration (S108) qui est conçu pour positionner la buse d'aspiration (32) en une position d'aspiration de composant par déplacement du robot (R1), sur la base de données de forme de dessus du composant (P) qui sont créées par le module de création de données de forme de dessus (S106) ;
un module de création de données de forme de dessous (S114) qui est conçu pour créer des données de forme de dessous du composant (P), sur la base de données d'image de forme de dessous du composant (P) dont une image est formée par le second dispositif de formation d'image (35) ;
un module de désignation de position de montage (S116) qui est conçu pour désigner une position pour le montage du composant (P) sur la carte (B) ; et
un module de création de données de montage (S216) qui est conçu pour créer les données de montage pour le montage du composant (P) sur la carte (B), sur la base de données de composant comprenant des données de forme de dessus et des données de forme de dessous qui sont créées par le module de création de données de forme de dessus (S106) et le module de création de données de forme de dessous (S114), et de données de la position de montage de composant désignée par le module de désignation de position de montage (S116).

2. Dispositif de création de données de montage selon la revendication 1, comprenant, en outre :
un module de mesure de hauteur qui est conçu pour mesurer une hauteur du composant (P),
dans lequel les données de hauteur du composant (P) qui est mesuré par le module de mesure de hauteur sont enregistrées dans les données de composant.

3. Dispositif de création de données de montage selon la revendication 1 ou 2, comprenant, en outre :
un module de calcul de grandeur de correction de position de montage qui est conçu pour calculer une grandeur de correction de la position de montage, sur la base de données d'image obtenues de telle manière que la position de montage de composant désignée par le module de désignation de position de montage (S116) est désignée en utilisant un motif de montage formé à l'avance sur la carte (B) et qu'une image du motif de montage désigné est formée par le premier dispositif de formation d'image (29).

4. Dispositif de création de données de montage selon l'une quelconque des revendications 1 à 3,
dans lequel le premier dispositif de formation d'image comprend une caméra de formation d'image de face de dessus de composant (29) permettant de former une image du composant (P) de dessus, et une caméra de formation d'image de carte (28) permettant de former une image d'une marque sur la carte (B).

5. Dispositif de création de données de montage selon la revendication 4,
dans lequel, dans le cas du robot, il est prévu deux robots (R1, R2), et
dans lequel la tête de montage (27) et la caméra de formation d'image de carte (28) sont disposées dans un robot (R1) et la caméra de formation d'image de face de dessus de composant (29) est disposée dans l'autre robot (R2).

6. Dispositif de création de données de montage selon l'une quelconque des revendications 1 à 5, comprenant, en outre :
un moyen d'inspection (14) permettant d'inspecter la position de montage du composant (P) monté sur la carte (B),
dans lequel les données de montage sont éditées, sur la base d'un résultat d'inspection du moyen d'inspection (14), et la carte (B) est produite en utilisant les données de montage éditées.

7. Système de production de carte comprenant :
un dispositif de création de données de montage selon la revendication 1 et un module de lecture de données (S202) qui est conçu pour lire des données de séquence des données de montage créées par le module de création de données de montage (S126).

8. Procédé de création de données de montage, comprenant :
la formation d'une image d'un composant (P), de dessus, par un premier dispositif de formation d'image (29) ;
la création de données de forme de dessus du composant (P), sur la base de données d'image de forme de dessus du composant (P) ;
le positionnement d'une buse d'aspiration (32) pour aspirer le composant (P) à une position d'aspiration, sur la base de données de forme de dessus ;
la formation d'une image du composant (P), de dessous, par un second dispositif de formation d'image (35) ;
la création de données de forme de dessous du composant (P), sur la base de données d'image de forme de dessous du composant (P) ;
la désignation d'une position de montage du composant (P) aspiré par la buse d'aspiration (32) ; et
la création de données de montage pour monter le composant (P) sur une carte (B), sur la base de données de composant comprenant des données de forme de dessus et des données de forme de dessous, et de données de la position de montage.
